# EUROPEAN PATENT APPLICATION

(11) **EP 4 535 938 A1**
(43) Date of publication of application: **09.04.2025**
(21) Application number: 23814820.9
(22) Date of filing: 21.04.2023
(51) Int. Cl.: H05K 5/00

(54) **WORKPIECE AND ELECTRONIC DEVICE**

(30) Priority: 31.05.2022 CN 202210610353
(71) Applicant: BYD Company Limited, Shenzhen, Guangdong 518118 (CN)
(72) Inventor: DUAN, Feifei, Shenzhen, Guangdong 518118 (CN); ZHAO, Lihong, Shenzhen, Guangdong 518118 (CN); LUO, Wenhai, Shenzhen, Guangdong 518118 (CN); ZHANG, Aodong, Shenzhen, Guangdong 518118 (CN); ZHU, Qiyu, Shenzhen, Guangdong 518118 (CN)
(74) Representative: Mathys & Squire
(86) International application number: PCT/CN2023/089721
(87) International publication number: WO 2023/231634

(57) **Abstract**

A workpiece and an electronic device. The workpiece comprises a substrate, wherein a texture layer is provided on the surface of one side of the substrate and comprises a plurality of first-level regions; each first-level region comprises a plurality of structural units; the plurality of structural units comprise at least a first structural unit and a second structural unit, which are connected to each other; the first structural unit and the second structural unit each internally comprise a plurality of sequentially arranged first texture stripes and a plurality of sequentially arranged second texture stripes; two ends of at least some first texture stripes both fall on the contour of the first structural unit; two ends of at least some second texture stripes both fall on the contour of the second structural unit; and the ends of the at least some first texture stripes are in contact with the ends of the at least some second texture stripes.

## Description

### CROSS-REFERENCE TO RELATED APPLICATIONS

The present disclosure claims priority to and benefits of Chinese Patent Application No. 202210610353.8, filed on May 31, 2022, and entitled "WORKPIECE AND ELECTRONIC DEVICE". The entire content of the above-referenced application is incorporated herein by reference.

### FIELD

The present disclosure relates to the field of workpiece manufacturing technologies, and specifically, to a workpiece and an electronic device.

### BACKGROUND

With the improvement of overall consumption levels, the market has an increasingly high requirement for textures of appearances of electronic devices. Currently, manufacturers usually arrange texture films in a housing of an electronic device to make the electronic device have beautiful appearance. However, the electronic device generally does not have a cool light and shade changing effect, making the electronic device appear less flexible.

### SUMMARY

In view of this, the present disclosure provides a workpiece and an electronic device, where protruding structures between texture layers on a surface of the workpiece can cooperate with each other to form a multi-segment curve, so that the surface of the workpiece has a hair texture pattern. In addition, the protruding structures cooperate with each other to refract and reflect light at different angles and intensities, thereby improving the multi-layeredness and flexibility of the hair texture pattern, enriching a visual effect of the workpiece, and enhancing the appearance aesthetics.

Specifically, according to a first aspect of the present disclosure, a workpiece is provided. The workpiece includes a substrate. A texture layer is provided on one side surface of the substrate. The texture layer includes a number of first-level regions. The first-level regions present a light and shade change and each of the first-level regions includes a number of structural units. The number of structural units at least include a first structural unit and a second structural unit connected to the first structural unit. The first structural unit includes a number of sequentially arranged first texture stripes, and two ends of at least some of the number of first texture stripes both fall on a contour of the first structural unit. The second structural unit includes a number of sequentially arranged second texture stripes, and two ends of at least some of the number of second texture stripes both fall on a contour of the second structural unit. End portions of the at least some first texture stripes are in contact with end portions of the at least some second texture stripes. Each texture stripe contained in each of the structural units is a protruding structure.

In some implementations, one ends of at least some first texture stripes are in contact with a number of second texture stripes.

In some implementations, an extension direction of each texture stripe in each of the structural units has a preset angle with a preset direction, and the preset angle is independently within a range of -90° to 90°.

In some implementations, the preset direction is a length direction or a width direction of the substrate.

In some implementations, at least some first-level regions in which the preset angle of each texture stripe in each single first-level region is within a range of -10° to 10° exist, and some first-level regions in which the preset angle of each texture stripe in each single first-level region is within a range of 80° to 90° and/or -90° to 80° also exist.

In some implementations, at least some first-level regions in which the preset angle of each texture stripe in each single first-level region is within a range of -30° to 30° exist; some first-level regions in which the preset angle of each texture stripe in each single first-level region is within a range of 60° to 90° and/or -90° to -60° also exist; and some first-level regions in which the preset angle of each texture stripe in each single first-level region is within a range of -60° to -30° and/or 30° to 60° further exist.

In some implementations, the first-level region with the preset angle ranging from -60° to -30° and/or 30° to 60° is located between the first-level region with the preset angle ranging from -30° to 30° and the first-level region with the preset angle ranging from 60° to 90° and/or -90° to 60°.

In some implementations, a width of the protruding structure gradually decreases in a direction away from the substrate.

In some implementations, a shape of a cross section of the protruding structure includes at least one of an arch and a polygon.

In some implementations, a width of the protruding structure ranges from 2 µm to 100 µm.

In some implementations, a height of the protruding structure is less than or equal to a maximum width of the protruding structure.

In some implementations, a number of protruding structures are consecutively arranged in the same structural unit.

In some implementations, a number of protruding structures are arranged at intervals in the same structural unit, and a distance between two adjacent protruding structures is less than the maximum width of the protruding structure.

In some implementations, a ratio of the maximum width to a length of the protruding structure is 1:(5 to 20).

In some implementations, a material of the substrate includes at least one of metal, glass, ceramic, and polymer composite material.

The texture layer on the surface of the workpiece has a number of first-level regions with different light and shade levels, which can present a dynamic effect similar to light and shade changes of hair in a real state. In addition, the surface of the workpiece has many protruding structures, which can reduce a contact area between human fingers and the surface of the workpiece, thereby preventing residual hand sweat and fingerprints, to maintain gorgeous appearance after long-term use.

According to a second aspect of the present disclosure, an electronic device is provided. The electronic device has the workpiece provided in the first aspect of the present disclosure. The electronic device has cool appearance, which can improve the appearance expressiveness and product competitiveness of the electronic device.

### BRIEF DESCRIPTION OF THE DRAWINGS

FIG. 1A is a grayscale image of a workpiece from one perspective according to an embodiment of the present disclosure;
FIG. 1B is a grayscale image of a workpiece from another perspective according to an embodiment of the present disclosure;
FIG. 1C is grayscale image of a workpiece from still another perspective according to an embodiment of the present disclosure;
FIG. 2 is a schematic partially enlarged view of a region A in FIG. 1A;
FIG. 3 is a schematic partially enlarged view of a region B in FIG. 1A;
FIG. 4 is a schematic partially enlarged view of a region C in FIG. 1A;
FIG. 5 is a schematic diagram of a principle of texture stripe connection;
FIG. 6 is a schematic structural diagram of a cross section of a workpiece according to an embodiment of the present disclosure;
FIG. 7 is a schematic structural diagram of a cross section of a texture layer of a workpiece according to Embodiment 1 of the present disclosure;
FIG. 8 is a schematic structural diagram of a cross section of a texture layer of a workpiece according to Embodiment 4 of the present disclosure;
FIG. 9 is a schematic structural diagram of a cross section of a texture layer of a workpiece according to Embodiment 5 of the present disclosure;
FIG. 10 is a partial micrograph of a texture layer of a workpiece according to Embodiment 1 of the present disclosure; and
FIG. 11 is a dimensional analysis result of a local texture structure of a texture layer of a workpiece according to an embodiment of the present disclosure.

List of reference numerals: 100-workpiece; 10-substrate; 20-texture layer; 21-first-level region; 22-structural unit; 221-texture stripe.

### DETAILED DESCRIPTION

The present disclosure provides a workpiece and an electronic device, where protruding structures between texture layers on a surface of the workpiece can cooperate with each other to form a multi-segment curve, so that the surface of the workpiece has a hair texture pattern. In addition, the protruding structures cooperate with each other to refract and reflect light at different angles and intensities, thereby improving the multi-layeredness and flexibility of the hair texture pattern, enriching a visual effect of the workpiece, and enhancing the appearance aesthetics.

The following describes in detail technical solutions in the present disclosure with reference to the accompanying drawings.

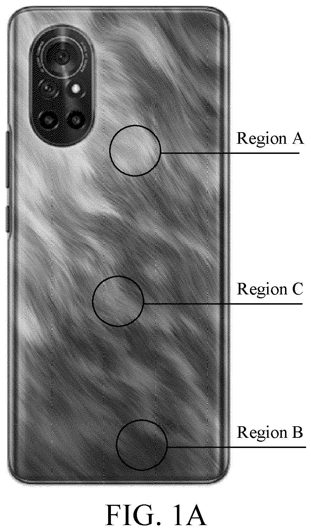

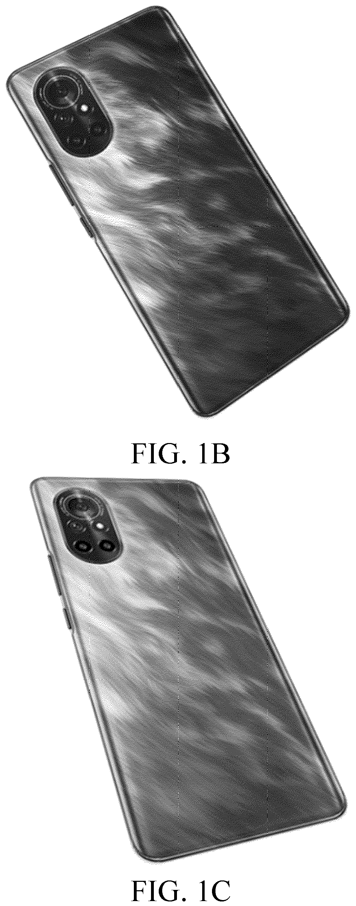

Referring to FIG. 1A to FIG. 7, an embodiment of the disclosure provides a workpiece. The workpiece 100 includes a substrate 10. A texture layer 20 is provided on one side surface of the substrate 10. The texture layer 20 includes a number of first-level regions 21. The first-level regions 21 present a light and shade change and each first-level region 21 includes a number of structural units 22. The number of structural units 22 at least include a first structural unit and a second structural unit connected to the first structural unit. The first structural unit includes a number of sequentially arranged first texture stripes, and two ends of at least some of the number of first texture stripes both fall on a contour of the first structural unit. The second structural unit includes a number of sequentially arranged second texture stripes, and two ends of at least some of the number of second texture stripes both fall on a contour of the second structural unit. End portions of the at least some first texture stripes are in contact with end portions of the at least some second texture stripes. Each texture stripe contained in each of the structural units is independently a protruding structure.

The texture layer on the surface of the workpiece has a number of first-level regions with different light and shade levels, which can present a dynamic effect similar to light and shade changes of hairs in a real state. In addition, the surface of the workpiece has many protruding structures, which can reduce a contact area between human fingers and the surface of the workpiece, thereby preventing residual hand sweat and fingerprints, so that the workpiece can still maintain gorgeous appearance after long-term use.

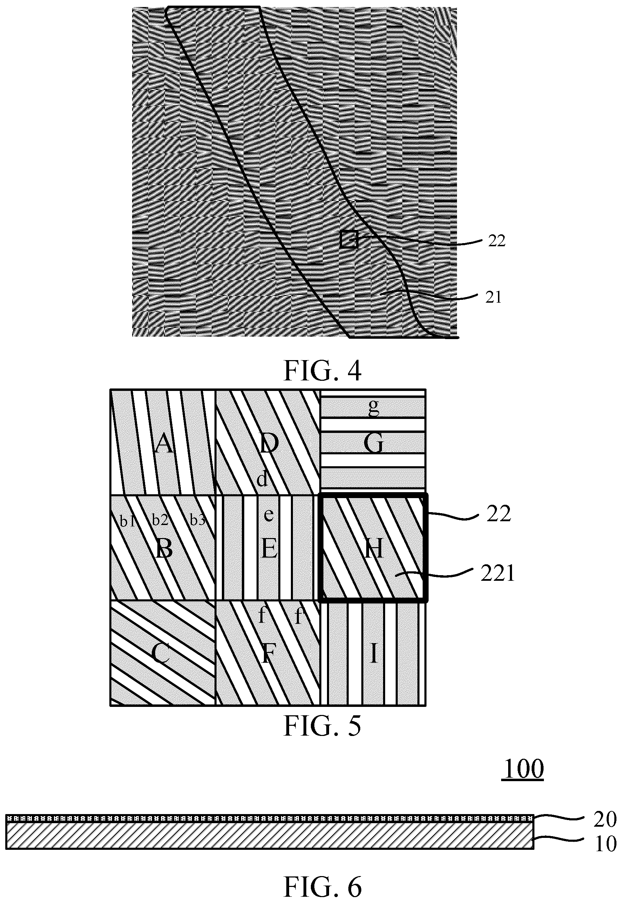

In the present disclosure, the first structural unit and the second structural unit are any two connected structural units among a number of structural units. For convenience of marking, each structural unit is marked as 21 in FIG. 1A to FIG. 5. Similarly, the first texture stripe and the second texture stripe are texture stripes in any two connected structural units respectively. For the convenience of marking, each texture stripe is marked as 221 in FIG. 5.

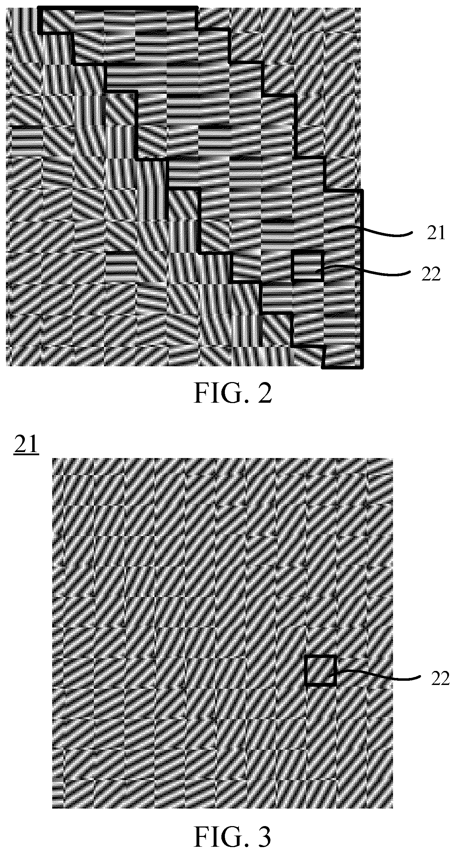

As shown in FIG. 2 to FIG. 5, the texture layer 20 is provided on the surface of the substrate 10, and the texture layer 20 includes a number of first-level regions 21 presenting a light and shade change. The light and shade change between different first-level regions are caused by different extension directions of texture stripes in the first-level regions. The extension directions of the texture stripes in each first-level region are the same or similar. Specifically, each texture stripe is independently a protruding structure, and the protruding structure has a number of light reflection angles. Due to the different extension directions, the brightness of light reflected by the protruding structure at a fixed light angle is different. Therefore, when a user observes the workpiece from a fixed angle, the surface of the workpiece may be divided into a number of first-level regions with different light brightness. When the user changes the observation angle, brightness of each first-level region will change accordingly, to bring rich visual feeling to the user.

Furthermore, each first-level region 21 includes a number of structural units 22, and the first structural unit and the second structural unit are any two connected structural units among a number of structural units 22. In both the first structural unit and the second structural unit, two ends of at least some first texture stripes or second texture stripes both fall on an outer contour of the structural unit, so that the first texture stripes and the second texture stripes may be in contact with each other. In addition, end portions of at least some first texture stripes are in contact with end portions of at least some second texture stripes. In this case, the first texture stripes and the second texture stripes may form a multi-segment curve.

For example, in a first structural unit with m first texture stripes inside, one ends of i of the m first texture stripes are in contact with j second texture stripes in a second structural unit, and the other ends of k of the n second texture stripes are in contact with r first texture stripes in another first structural unit (m, n, j, i, k, r are all integers, m≥2, n≥2, i≥1, j≥1, k≥1, r≥1 and their respective values may be the same or different), so that at least one multi-segment curve including three texture stripes 221 may be formed. Specifically, as shown in FIG. 5, in a first structural unit B, one ends of three first texture stripes (b 1, b2, b3) among four texture stripes in B are connected to three second texture stripes in a second structural unit A, where the other ends of b1 and b2 are also in contact with two second texture stripes in a second structural unit C respectively, so that a number of multi-segment curves including three texture stripes 221 are formed. The structural units A and C have other adjacent structural units, and by analogy, more multi-segment curves including different quantities of texture stripes 221 may be formed, so that multi-segment curves with different lengths may be formed. When the user observes the workpiece, each multi-segment curve is similar to a hair.

In addition, as can be known from the above content, there must be some texture stripes 221 having different extension directions (including similar or very different situations), so that the multi-segment curves may have different bending degrees, lengths, and extension directions, and finally the surface of the workpiece can present a hair-like pattern with rich layers.

In summary, the texture layer 20 on the surface of the workpiece 100 has different light and shade levels, and can present a dynamic effect similar to hairs in a real state. That is, as light and an observation angle change, the hair texture pattern on the surface of the workpiece 100 also produces a light and dark alternated flowing effect, which is multi-layered and flexible, has rich visual effects, and brings great artistic beauty. In addition, the surface of the workpiece 100 has many protruding structures. This concave-convex structure can reduce the contact area between human hands and the surface of the workpiece, thereby preventing residual hand sweat and fingerprints, so that the workpiece 100 can still maintain gorgeous appearance after long-term use.

In the present disclosure, a shape of the first-level region 21 can be regular or irregular. For example, the first-level region may be circular, irregularly curved, annular, or the like.

In the present disclosure, in some cases, dark stripes and white stripes in FIG. 2 to FIG. 4 may all represent texture stripes 221 (that is, protruding structures). In some other cases, the dark stripe patterns in FIG. 2 to FIG. 4 represent texture stripes 221, and the white stripe patterns represent intervals between two adjacent texture stripes 221 in the same structural unit 22. That is, the texture stripes 221 in the structural unit 22 may be connected to each other or arranged at intervals, but in either case, there is a boundary between adjacent texture stripes 221, and surfaces of the substrate 10 corresponding to the adj acent texture stripes 221 are each covered with a protruding structure.

In the present disclosure, a shape of the structural unit 22 is not specifically limited, which may be a rectangle, a circle, a sector, a polygon, an irregular shape, or the like, as long as a number of structural units 22 can match each other to form a continuous texture layer 20.

In the present disclosure, the contact between texture stripes 221 may refer to that the two texture stripes 221 are completely connected, or may refer to that the two texture stripes 221 are connected in a misaligned manner, as long as the two texture stripes 221 have an intersection.

In some implementations of the present disclosure, two ends of at least some first texture stripes are in contact with a number of second texture stripes. The number of second texture stripes may come from the same second structural unit or from different second structural units. It may be understood that, in this case, it is equivalent to forming a tree-like structure. For example, referring to FIG. 3, one end of a texture stripe e in FIG. 3 is in contact with texture stripes f and f, and two multi-segment curves d-e-f and d-e-f intersect with each other. When the user quickly changes the observation angle, the hair-like pattern will produce a flowing effect, which can further enrich the visual effect of the workpiece.

In some implementations of the present disclosure, an extension direction of each texture stripe 221 in each structural unit 22 has a preset angle with a preset direction, and the preset angle is independently within a range of -90° to 90°. The preset direction is a length direction or a width direction of the workpiece 100 (specifically, a length direction or a width direction of the substrate 10). When discussing a positional relationship of texture stripes 221 on a workpiece 100, the texture stripes 221 need to use one of the length direction and the width direction of the workpiece 100 as the preset direction. Specifically, taking FIG. 5 as an example, a preset angle between an extension direction of a texture stripe g in FIG. 5 and the preset direction is 0°, and a preset angle between an extension direction of the texture stripe e and the preset direction is 90° (or -90°). The user observes the workpiece 100 from an angle, and when the preset angles of most texture stripes 221 (that is, the protruding structures) in a first-level region are within a range of - 30° to 30° (referring to a region A in FIG. 1A and the first-level region 21 marked in FIG. 2), the first-level region is an apparent highlight region; when the preset angles of most texture stripes 221 in a first-level region are within a range of -90° to -60° or 60° to 90°, the first-level region is an apparent dark region (referring to a region B in FIG. 1A and FIG. 3); and it may be understood that when the preset angles of most texture stripes 221 in a first-level region are within a range of -60° to -30° or 30° to 60°, the first-level region is a transition region with brightness between the foregoing two regions (referring to a region C in FIG. 1A and the first-level region 21 marked in FIG. 4).

In some implementations of the present disclosure, at least some first-level regions 21 in which the preset angle of each texture stripe 221 in each single first-level region 21 is within a range of -10° to 10° exist, and some first-level regions 21 in which the preset angle of each texture stripe 221 in each single first-level region 21 is within a range of 80° to 90° and/or - 90° to -80° also exist. In this case, the surface of the workpiece 100 has relatively prominent highlight regions and dark regions, which is conducive to further enriching the appearance of the workpiece 100. In addition, curvatures of multi-segment curves in the same first-level region 21 are transited naturally, thereby making the hair texture of the workpiece 100 more natural and real.

In some implementations of the present disclosure, at least some first-level regions 21 in which the preset angle of each texture stripe 221 in each single first-level region 21 is within a range of -30° to 30° (denoted by first-level regions X) exist; some first-level regions 21 in which the preset angle of each texture stripe 221 in each single first-level region 21 is within a range of 60° to 90° and/or -90° to -60° (denoted by first-level regions Y) also exist; and some first-level regions 21 in which the preset angle of each texture stripe 221 in each first-level region 21 is within a range of -60° to -30° and/or 30° to 60° (denoted by first-level regions Z) further exist. In this case, the light and shade effects on the surface of the workpiece 100 are richer. In addition, the presented hair texture can be more natural and real.

In some implementations of the present disclosure, the first-level region Z is located between the first-level region X and the first-level region Y. In this case, the surface of the workpiece 100 has a highlight region, a dark region, and a transition region between the highlight region and the dark region, which can make light and shade transition on the surface of the workpiece 100 more natural, so that the workpiece is more aesthetically pleasing.

In some implementations of the present disclosure, a width of the protruding structure gradually decreases in a direction away from the substrate 10. In this case, when the user changes the observation angle, a dynamic changing effect of light and shadow of the workpiece is more apparent.

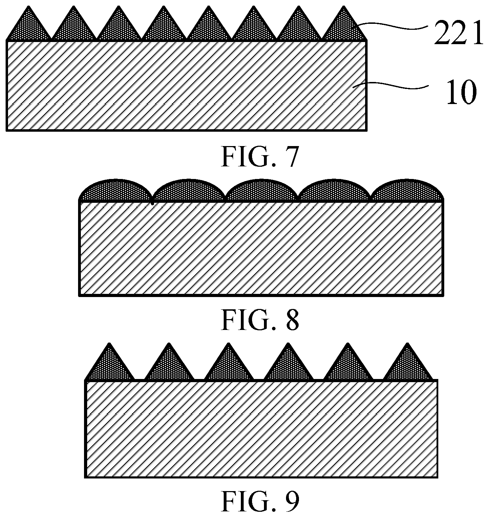

Referring to FIG. 7 to FIG. 9 together, in some implementations of the present disclosure, a shape of a cross section of the protruding structure (the cross section is parallel to a thickness direction of the substrate 10) includes but is not limited to at least one of an arch and a polygon. The shapes of the cross sections of the protruding structures may be the same or different. For example, the polygon may be a triangle, a trapezoid, or the like, and correspondingly, the shape of the protruding structure is a prism, a quadrangular prism, or the like, provided that the protruding structure has a number of light reflection angles under irradiation of light.

In some implementations of present disclosure, the width of the protruding structure ranges from 2 µm to 100 µm. For example, the width of the protruding structure may be 2 µm, 5 µm, 7 µm, 10 µm, 15 µm, 20 µm, 25 µm, 30 µm, 40 µm, 50 µm, 60 µm, 70 µm, 80 µm, 90 µm, 100 µm, or the like. The widths of the protruding structures may be the same or different. In this case, a size of each protruding structure is relatively small, which can ensure that each structural unit 22 can have a relatively large number of protruding structures. On the other hand, the protruding structures with suitable sizes can better present a smooth hair-like pattern, ensuring that the workpiece 100 has rich appearance. In addition, the protruding structures of the foregoing size are relatively easy to prepare.

In some implementations of the present disclosure, a ratio of a maximum width to a length of the protruding structure is 1:(5 to 20). The protruding structure has a suitable aspect ratio, which is conducive to controlling the smoothness of the multi-segment curve (hair).

In some implementations of the present disclosure, a height of the protruding structure is less than or equal to the maximum width of the protruding structure. This is conducive to preparation of the workpiece 100 and to ensuring the aesthetics of the workpiece 100.

In some implementations of the present disclosure, a number of protruding structures are consecutively arranged in the same structural unit 22. In this case, it is conducive to ensuring that each structural unit 22 has as much protruding structures as possible, so that the appearance of the workpiece 100 is more gorgeous.

In some implementations of the present disclosure, a number of protruding structures are arranged at intervals in the same structural unit 22, and a distance between two adjacent protruding structures is less than the maximum width of the protruding structure. In the same structural unit 22, the distance between any two adjacent protruding structures may be the same or different. The distances between adjacent protruding structures in different structural units 22 may be the same or different. A distance exists between the protruding structures, so that a density of the protruding structures in the texture layer 20 can be reduced and the difficulty of a production process of the workpiece 100 can be reduced. However, the appearance of a flowing hair-like pattern of the workpiece 100 can only be ensured with a suitable density. A person of ordinary skill in the art can select the density of the protruding structures according to an actual production requirement and a customer requirement, as long as the appearance effect of the workpiece 100 can be achieved.

In the present disclosure, a material and a thickness of the substrate 10 are not specifically limited, which can be selected according to a user requirement. Specifically, the material of the substrate 10 includes but is not limited to metal, glass, ceramic, polymer composite material, and the like.

In the present disclosure, a method for preparing the workpiece 100 may be a technical method well known to a person of ordinary skill in the art. In some specific embodiments, the following steps are included:
(1) A mold with a texture layer structure is prepared through photolithography.
(2) A texture layer is formed on a surface of a substrate to obtain a workpiece.

Specifically, a hair-like planar pattern may be designed in advance, and then layer decomposition can be performed by using software according to light and shade characteristics of different regions of the planar pattern. Then, texture structural parameters of each decomposed layer are set to design and complete a hair texture structure with a dynamic light and shadow changing effect. Finally, the structural parameters of the layers are translated into a photolithography data file, to obtain the mold with the texture layer structure through photolithography.

A method for forming the texture layer on the surface of the substrate can be selected according to the material of the substrate. For example, processes such as UV transfer printing, in-mold injection molding, injection molding, glass laminating, chemical etching, optical coating, and electroforming may be used.

An embodiment of the present disclosure further provides an electronic device, which carries the workpiece 100 provided in the embodiments of the present disclosure. The electronic device includes but is not limited to a mobile phone, a tablet computer, a notebook computer, a smart watch, an e-cigarette, or the like. For example, the workpiece 100 may be processed into a shell of a mobile phone, a tablet computer, a notebook computer, or a smart watch, and may alternatively be processed into a relevant part of an e-cigarette, so that the electronic device can have a cool appearance effect, which can improve the appearance expressiveness and product competitiveness of the electronic device.

In addition, the workpiece 100 may alternatively be processed into a luxury nameplate to improve the artistry of the product.

The technical solutions of the present disclosure are described below in detail with reference to specific embodiments.

### Embodiment 1

In Embodiment 1, the workpiece is a rear cover of a mobile phone, and the substrate is made of glass. In each structural unit, the texture stripes are arranged without a distance, and the protruding structure is a triangular prism with a width of 10 µm and a height of 1.5 µm.

### Embodiment 2

A difference from Embodiment 1 is that: the protruding structure is a triangular prism with a width of 100 µm and a height of 50 µm.

### Embodiment 3

A difference from Embodiment 1 is that: the protruding structure is a triangular prism with a width of 2 µm and a height of 1 µm.

### Embodiment 4

A difference from Embodiment 1 is that: a cross section of the protruding structure is in a shape of an arch.

### Embodiment 5

Differences from Embodiment 1 are that: in each structural unit, the texture stripes are arranged at intervals, a distance between adjacent texture stripes is 10 µm, and the protruding structure is a triangular prism with a width of 50 µm and a height of 30 µm.

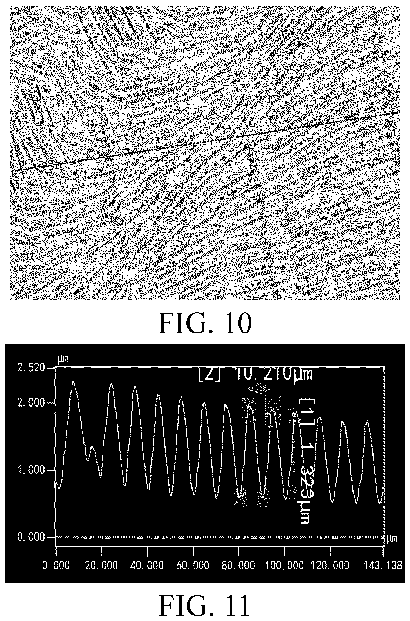

FIG. 10 and FIG. 11 are respectively photos of a local area of the rear cover of the mobile phone in Embodiment 1 under a microscope and a texture structure size analysis. Numerous structural units constitute a hair texture pattern of a rear cover of a housing. FIG. 1A to FIG. 1C are grayscale images of the rear cover of the mobile phone obtained in Embodiment 1 at different observation angles. It can be clearly seen that the hair pattern in the same region of the rear cover of the mobile phone generate light and shade changes as the observation angle changes, and the hair lines of the pattern of the rear cover are smooth, which are multi-layered and flexible.

The foregoing describes exemplary implementations of the present disclosure. It should be noted that for a person of ordinary skill in this technical field, several improvements and modifications can be further made to the present disclosure without departing from the principle of the present disclosure, and these improvements and modifications are also considered to fall within the protection scope of the present disclosure.

## Claims

1. A workpiece (100), the workpiece (100) comprising a substrate (10), a texture layer (20) being provided on one side surface of the substrate (10), the texture layer (20) comprising a plurality of first-level regions (21), the plurality of first-level regions (21) presenting a light and shade change and each of the first-level regions (21) comprising a plurality of structural units (22), the plurality of structural units (22) at least comprising a first structural unit and a second structural unit connected to the first structural unit, the first structural unit comprising a plurality of sequentially arranged first texture stripes, two ends of at least some of the plurality of first texture stripes both falling on a contour of the first structural unit (22), the second structural unit comprising a plurality of sequentially arranged second texture stripes, and two ends of at least some of the plurality of second texture stripes both falling on a contour of the second structural unit; end portions of the at least some first texture stripes being in contact with end portions of the at least some second texture stripes; and each texture stripe (221) contained in each of the structural units (22) being independently a protruding structure.

2. The workpiece (100) according to claim 1, wherein one ends of at least some first texture stripes are in contact with a plurality of second texture stripes.

3. The workpiece (100) according to claim 1 or 2, wherein an extension direction of each texture stripe (221) in each of the structural units (22) has a preset angle with a preset direction, and the preset angle is independently within a range of -90° to 90°.

4. The workpiece (100) according to claim 3, wherein the preset direction is a length direction or a width direction of the substrate (10).

5. The workpiece (100) according to claim 3 or 4, wherein at least some first-level regions (21) in which the preset angle of each texture stripe (221) in each single first-level region (21) is within a range of -10° to 10° exist, and some first-level regions (21) in which the preset angle of each texture stripe (221) in each single first-level region (21) is within a range of 80° to 90° and/or -90° to -80° also exist.

6. The workpiece (100) according to claim 3 or 4, wherein at least some first-level regions (21) in which the preset angle of each texture stripe (221) in each single first-level region (21) is within a range of -30° to 30° exist; some first-level regions (21) in which the preset angle of each texture stripe (221) in each single first-level region (21) is within a range of 60° to 90° and/or -90° to - 60° also exist; and some first-level regions (21) in which the preset angle of each texture stripe (221) in each single first-level region (21) is within a range of -60° to -30° and/or 30° to 60° further exist.

7. The workpiece (100) according to claim 6, wherein the first-level region (21) with the preset angle ranging from -60° to -30° and/or 30° to 60° is located between the first-level region (21) with the preset angle ranging from -30° to 30° and the first-level region (21) with the preset angle ranging from 60° to 90° and/or -90° to -60°.

8. The workpiece (100) according to any of claims 1 to 7, wherein a width of the protruding structure gradually decreases in a direction away from the substrate (10).

9. The workpiece (100) according to any of claims 1 to 7, wherein a shape of a cross section of the protruding structure comprises at least one of an arch and a polygon.

10. The workpiece (100) according to any of claims 1 to 9, wherein the width of the protruding structure ranges from 2 µm to 100 µm.

11. The workpiece (100) according to claim 10, wherein a height of the protruding structure is less than or equal to a maximum width of the protruding structure.

12. The workpiece (100) according to any of claims 1 to 11, wherein a plurality of protruding structures are consecutively arranged in the same structural unit (22).

13. The workpiece (100) according to any of claims 1 to 11, wherein a plurality of protruding structures are arranged at internals in the same structural unit (22), and a distance between two adjacent protruding structures is less than the maximum width of the protruding structure.

14. The workpiece (100) according to any of claims 1 to 13, wherein a ratio of the maximum width to a length of the protruding structure is 1:(5 to 20).

15. The workpiece (100) according to any of claims 1 to 14, wherein a material of the substrate (10) comprises at least one of metal, glass, ceramic, and polymer composite material.

16. An electronic device, comprising the workpiece (100) according to any one of claims 1 to 15.
